# EUROPEAN PATENT SPECIFICATION

(11) **EP 4 052 284 B1**
(45) Date of publication and mention of the grant of the patent: **22.07.2026**
(21) Application number: 20882515.8
(22) Date of filing: 30.10.2020
(51) Int. Cl.: H10H 20/84, H10H 20/824, H10P 14/24, H10P 14/20, H10H 20/01

(54) **GALLIUM-CONTAINING LIGHT-EMITTING DEVICE**
GALLIUM ENTHALTENDE LICHTEMITTIERENDE VORRICHTUNG
DISPOSITIF ÉLECTROLUMINESCENT CONTENANT DU GALLIUM

(30) Priority: 30.10.2019 US 201962927859 P
(43) Date of publication of application: 07.09.2022
(73) Proprietor: The Regents of the University of California, Oakland, CA 94607-5200 (US)
(72) Inventor: WONG, Matthew S., Santa Barbara, CA 93111 (US); SMITH, Jordan M., Goleta, CA 93117 (US); DENBAARS, Steven P., Goleta, CA 93117 (US)
(74) Representative: Meissner Bolte Nürnberg
(86) International application number: PCT/US2020/058234
(87) International publication number: WO 2021/087274

(56) References cited:
- WO-A1-2019/089697
- CN-A- 107 768 235
- DE-A1- 102017 112 875
- US-A1- 2004 147 054
- US-A1- 2013 161 643
- US-A1- 2014 084 340
- US-A1- 2015 162 412
- US-A1- 2017 170 360
- US-A1- 2019 067 453
- US-A1- 2020 111 937
- US-A1- 2021 193 871
- "Gallium nitride", WIKIPEDIA, 25 December 2020 (2020-12-25), XP055930659, Retrieved from the Internet <URL:https://en.wikipedia.org/wiki/Gallium_nitride>

## Description

### BACKGROUND OF THE INVENTION

### 1. Field of the Invention.

This invention relates generally to light emitting diodes (LEDs).

### 2. Description of the Related Art.

In recent years, the developments of displays with superior resolution and color gamut have gained significant research attention. Micro-sized LEDs (also referred to as micro-LEDs or µLEDs) are considered as the most promising display technology for next-generation display applications. However, there are challenges required to be resolved before applying this technology for commercial production.

Among all the challenges, the material choice for the red µLEDs is one of the main problems for µLED displays. For full-color displays, red (~630 nm), green (~525 nm), and blue (~480 nm) colors are required. Highly efficient blue and green light emitting µLEDs using the InGaN material system have been demonstrated and are commercially available, yet high performance red light emitting LEDs using the InGaN material system have not been developed and are very difficult to realize due to material reasons.

On the other hand, conventional III-V semiconductor materials, namely the AlGaInP/GaAs material systems, have been employed as mature red emitters for a variety of commercial usages. The AlGaInP devices operate well in large dimensions, but efficiency decreases dramatically as the device shrinks, since the AlGaInP material system has a high minority carrier diffusion length that causes issues such as leakage current and non-radiative recombination.

Thus, there is a need in the art for improved methods for fabricating AlGaInP-based µLEDs. The present invention satisfies this need.

US 2017/0170360 A1 discloses a light emitting diode comprising a p-n doped diode layer including a top doped layer, a bottom doped layer and an active layer between top doped layer and bottom doped layer.

### SUMMARY OF THE INVENTION

The present invention relates to a device according to claim 1. Advantageous embodiments are set out in the dependent claims..

### BRIEF DESCRIPTION OF THE DRAWINGS

FIG. 1 shows a schematic of a semiconductor material grown on the substrate.
FIG. 2 shows a schematic of a semiconductor material, including n-type doped, active and p-type doped layers.
FIG. 3 shows a diagram of the sidewall profile of a device after a nitrogen plasma treatment.
FIGS. 4 and 5 show forward current-voltage characteristics from 0 to 3.5 V and from -4 to 3.5 V of 20x20 µm² AlGaInP µLEDs.
FIGS. 6 and 7 present light output power and efficiency curves of 100x100 and 20x20 µm² AlGaInP µLEDs.
FIGS. 8 and 9 demonstrate leakage current density and efficiency for different device dimensions with different sidewall passivation techniques.
FIG. 10 is a flowchart of the process steps of the invention.

### DETAILED DESCRIPTION OF THE INVENTION

In the following description of the preferred embodiment, reference is made to the accompanying drawings which form a part hereof, and in which is shown by way of illustration a specific embodiment in which the invention may be practiced. It is to be understood that other embodiments may be utilized and structural changes may be made without departing from the scope of the present invention.

### Technical Description

In this invention, inorganic semiconductor materials are grown on a substrate, where the inorganic semiconductor material comprised of group III and group V elements with a chemical formula of AlₓGa_{y}In_{z}NᵥP_{w}A_{Su} where 0 ≤ x ≤ 1, 0 ≤ y ≤ 1, 0 ≤ z ≤ 1, 0 ≤ v ≤ 1, 0 ≤ w ≤ 1, 0 ≤ u ≤ 1, v + w + u = 1, and x + y + z = 1. The substrate used can be optically transparent, semi-transparent, or opaque, and can be electrically conductive, semi-insulative, or insulative.

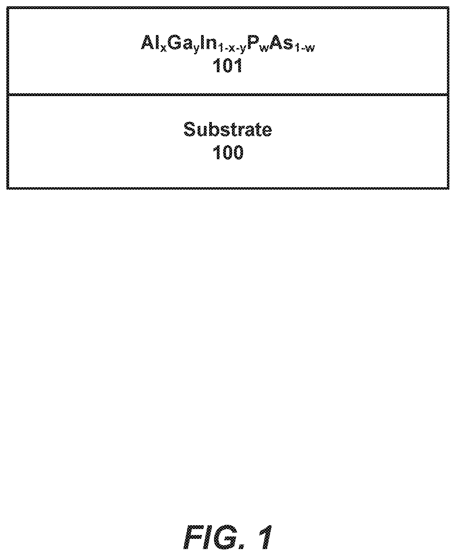

FIG. 1 shows a schematic of semiconductor material comprised of a substrate 100 and AlₓGa_{y}In_{1-x-y}P_{w}A_{S1-w} 101 grown on the substrate 100.

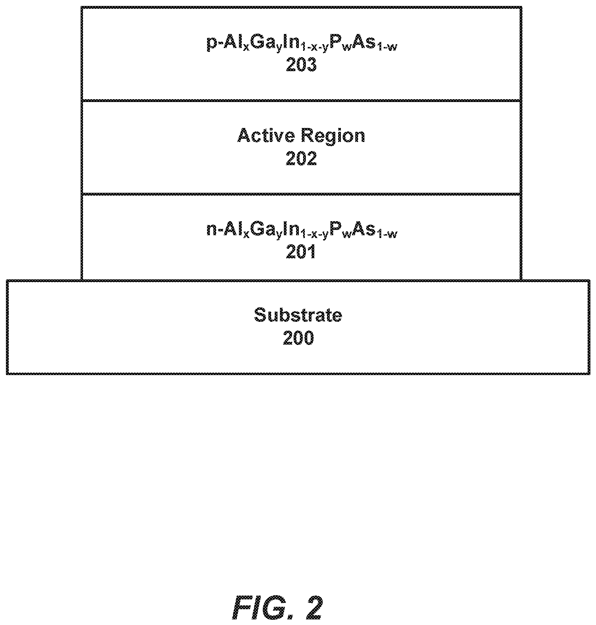

FIG. 2 shows a schematic of semiconductor material comprised of a substrate 200, n-type doped AlₓGa_{y}In_{1-x-y}P_{w}A_{S1-w} 201 grown on the substrate 200, followed by growth of an active region 202 and p-type doped AlₓGa_{y}In_{1-x-y}P_{w}A_{S1-w} 203.

Plasma-based dry etching is used to define the light-emitting area of the semiconductor material, also known as a mesa, by etching through the active region where light is emitted. After the etching step, the semiconductor material is sent to a vacuum chamber for sidewall treatment, wherein the vacuum chamber has the abilities of etching and deposition.

The semiconductor material can be sent to an etch chamber if the semiconductor material is exposed to ambient conditions after the mesa etching, since oxygen serves as non-radiative sites of the semiconductor material. In the etch chamber, a thin layer of the semiconductor material, on the order of nanometer scale, can be removed by low-power dry etching to eliminate the presence of oxygen atoms on exposed surfaces. This etching step further improves device performance.

The surface of the etched semiconductor material is then treated with alternating pulse cycles of trimethyl aluminum (TMA) and nitrogen/hydrogen plasma. This TMA and plasma surface treatment suppresses the effects of dry damage by removing non-radiative combination sites, reducing the surface sites, and filling the vacancies by nitrogen. The use of hydrogen plasma is not as critical as nitrogen plasma, because hydrogen plasma may react with other components on the substrate. The nitrogen plasma employed in the surface treatment is low power, such that the device is not damaged and there is no deposition from the metalorganic and plasma.

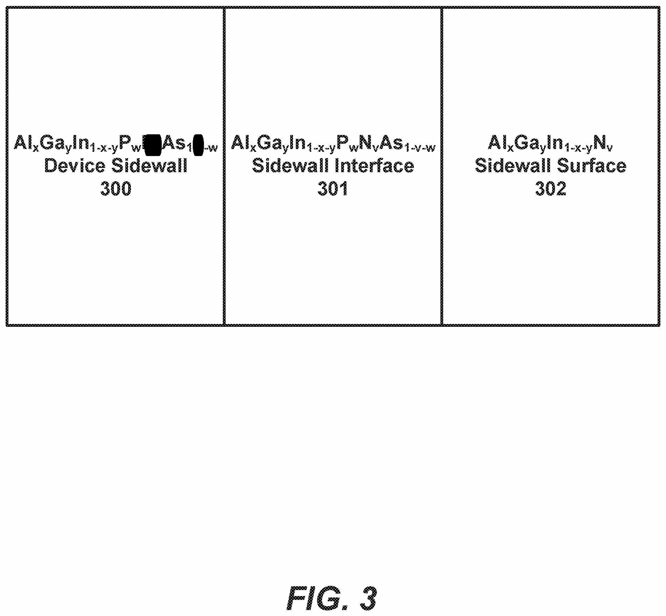

FIG. 3 shows a diagram of the sidewall profile of an AlGaInP device after the nitrogen plasma treatment, including an AlₓGa_{y}In_{1-x-y}P_{w}A_{S1-w} device sidewall 300, AlₓGa_{y}In_{1-x-y}P_{w}NᵥA_{S1-v-w} sidewall interface 301 and AlₓGa_{y}In_{1-x-y}Nᵥ sidewall surface 302.

In additional to lessening the influences of sidewall damage from defining the mesa, the use of nitrogen plasma incorporates nitrogen atoms at the semiconductor material interface, and increases the bandgap at the surface and the interface for AlGaInP materials. Since nitride forms stronger chemical bonds with group III elements than phosphide and arsenide, the bandgap of nitride is greater than phosphide and arsenide, and thus the injected current is less able to reach to the sidewall after the nitrogen plasma treatment. The plasma approach is more attractive for AlGaInP device fabrication, because the AlGaInP material system has different reactivity and sensitivity to acidic or basic wet chemical treatment, and thus a plasma-based surface treatment is a more reliable and repeatable method.

In terms of nitride semiconductor material (e.g., AlₓGa_{y}In_{1-x-y}Nᵥ), nitrogen vacancies are generated after dry etching of the mesa and these nitrogen vacancies act as leakage paths and non-radiative recombination sites. By employing nitrogen plasma on the sidewall of the nitride semiconductor material, the nitrogen plasma compensates the nitrogen vacancies and enhances the device performances.

After the TMA and nitrogen plasma surface treatment, dielectric sidewall passivation is used to cover the surface of the semiconductor material with dielectric materials to terminate any surface recombination sites. The dielectric deposition method should cause no damage to the device while providing superior dielectric material quality. Atomic layer deposition (ALD) offers damage-free material deposition with excellent material quality.

The benefits of such sidewall treatments include better forward and reverse current-voltage device characteristics and enhancements in light output power. As a result, the efficiency of the small device also improves significantly with sidewall treatment.

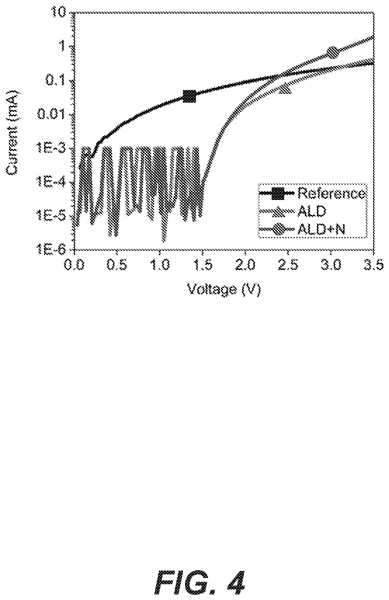

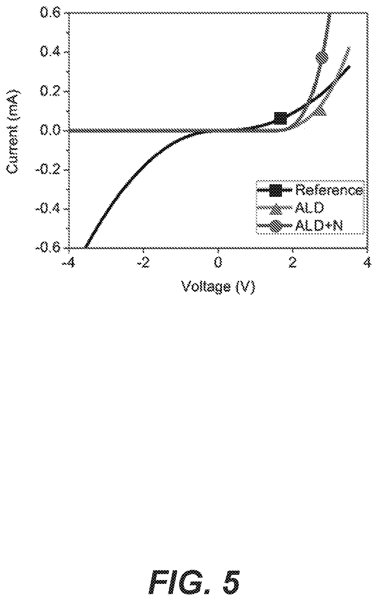

FIGS. 4 and 5 are graphs of Current (mA) vs. Voltage (V) that show the forward current-voltage characteristics from 0 to 3.5 V and from -4 to 3.5 V of 20x20 µm² AlGaInP µLEDs, wherein "Reference" refers to µLEDs without sidewall treatment, and "ALD" and "ALD+N" represent devices with Al₂O₃ sidewall passivation by ALD without and with TMA and nitrogen plasma surface treatments.

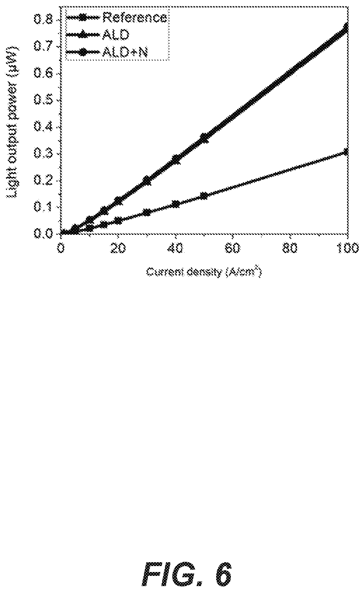

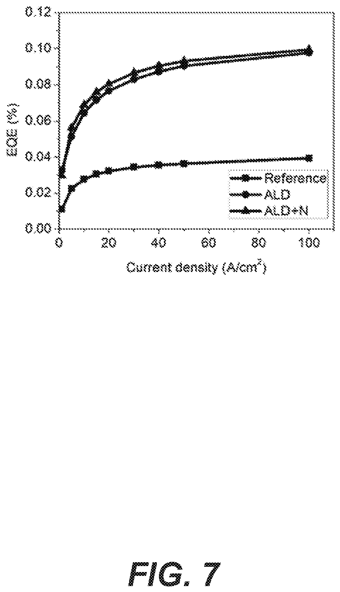

FIGS. 6 and 7 are graphs of Light Output Power (LOP) (µW) vs. Current Density (A/cm²) present the light output power and efficiency curves of 100x100 and 20x20 µm² AlGaInP µLEDs, wherein "Reference" refers to µLEDs without sidewall treatment, and "ALD" and "ALD+N" represent devices with Al₂O₃ sidewall passivation by ALD without and with TMA and nitrogen plasma surface treatments.

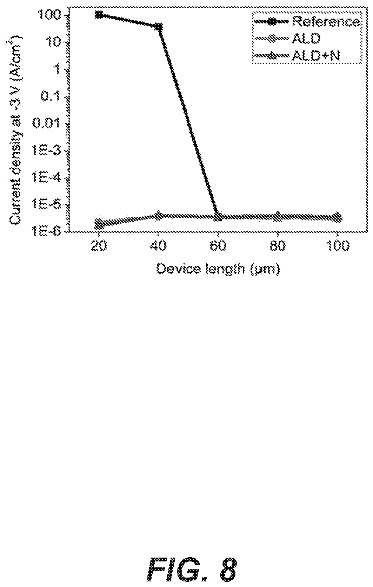

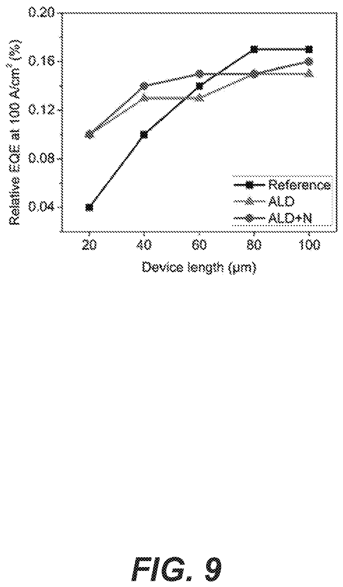

FIGS. 8 and 9 are graphs of Relative External Quantum Efficiency (EQE) at 100 A/cm² (%) vs. Device Length (µm), wherein "Reference" refers to µLEDs without sidewall treatment, and "ALD" and "ALD+N" represent devices with Al₂O₃ sidewall passivation by ALD without and with TMA and nitrogen plasma surface treatments. These graphs demonstrate the leakage current density and efficiency for different device dimensions with different sidewall passivation techniques.

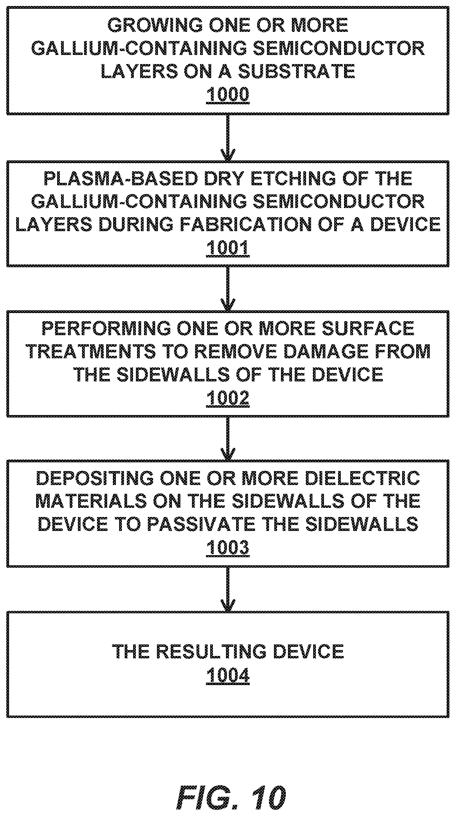

FIG. 10 is a flowchart of the process steps of this invention recited above.

Block 1000 represents the step of growing one or more gallium-containing semiconductor layers on a substrate. The gallium-containing semiconductor layers include one or more nitrogen, phosphorus, and/or arsenic atoms as counter atoms.

Block 1001 represents the step of plasma-based dry etching of the gallium-containing semiconductor layers during fabrication of a device.

Block 1002 represents the step of performing one or more surface treatments to remove damage or to alter a surface chemistry from sidewalls of the device, after the dry etching of the gallium-containing semiconductor layers. The surface treatments may comprise thermal-based or plasma-based nitridation, oxidation, and/or other surface chemistry modification techniques. In one or more embodiments, the surface treatments take place at a temperature above 25°C. In one or more embodiments, a source of plasma can be from gases, metalorganics, and/or other volatile chemicals. In one or more embodiments, the surface treatments are performed at a low power level to avoid physical deposition and damage to the device.

Block 1003 represents the step of depositing one or more dielectric materials on sidewalls of the device to passivate the sidewalls of the device, after the surface treatments of the sidewalls. In one or more embodiments, the dielectric deposition is conformal or uniform in covering the sidewalls. In one or more embodiments, the dielectric is deposited by atomic layer deposition, sputtering, plasma-enhanced chemical vapor deposition, and/or other chemical vapor deposition. In one or more embodiments, this step may further comprise a post-dielectric deposition to improve material quality and an interface between the dielectric materials and the sidewalls, such as annealing.

In one or more embodiments, material is removed at the device's surface prior to the performing the surface treatment and depositing the dielectric materials.

Block 1004 represents a resulting device, wherein the performing and depositing steps result in an improvement in forward current-voltage characteristics and reduction in leakage current of the resulting device, as well as an enhancement of light output power and efficiency of the resulting device. In one or more embodiments, the device has a sidewall-perimeter to light-emitting area ratio larger than 0.04 µm⁻¹, and the device has one or more edges with a length of less than 80 µm.

### Benefits and Advantages

AlGaInP/GaAs system is a very mature material system for typical lighting applications, where the device size is large. Nevertheless, because of the inherent material properties, the main obstacles of using this material for µLEDs are the high leakage current and low energy efficiency at small device dimensions. This invention resolves the problems of leakage current and efficiency of AlGaInP µLEDs by employing device fabrication techniques that are easy to adopt. With low leakage current and good efficiency, AlGaInP µLEDs can be used as the red emitter in µLED displays.

### Conclusion

This concludes the description of the preferred embodiment of the present invention. The foregoing description of one or more embodiments of the invention has been presented for the purposes of illustration and description. It is not intended to be exhaustive or to limit the invention to the precise form disclosed. Many modifications and variations are possible in light of the above teaching. It is intended that the scope of the invention be limited not by this detailed description, but rather by the claims appended hereto.

## Claims

1. A device, comprising:
one or more gallium-containing semiconductor layers grown on a substrate and forming a micro light emitting diode (microLED), wherein the gallium-containing semiconductor layers include materials that comprise group III and group V elements with a chemical formula of AlₓGa_{y}In_{z}NᵥP_{w}Asᵤ where 0≤x≤1, 0≤y≤1, 0≤z≤1, 0≤v≤1, 0≤w≤1, 0≤u≤1, v+w+u=1, and x+y+z=1, wherein the materials are comprised of a substrate (100, 200) and AlₓGa_{y}In_{1-x-y}P_{w}As_{1-w} (101) grown on the substrate (100, 200) or wherein the materials are comprised of a substrate (100, 200) and n-type doped AlₓGa_{y}In_{1-x-y}P_{w}As_{1-w} (201) grown on the substrate (100, 200), followed by growth of an active region (202) and p-type doped AlₓGa_{y}In_{1-x-y}P_{w}As_{1-w} (203);
wherein the gallium-containing semiconductor layers are dry-etched to define a mesa of the micro light emitting diode and sidewalls of the mesa;
wherein the sidewalls of the dry-etched mesa of the micro light emitting diode are surface-treated by alternating pulse cycles of trimethyl aluminum (TMA) and low power nitrogen plasma to remove damage from the sidewalls that were dry-etched or to alter a surface chemistry of the sidewalls, such that there is no deposition from the TMA and nitrogen plasma and such that the device is an AlGaInP device after the nitrogen plasma treatment, including an Alₓ Ga_{y} In_{1-x-y} P_{w} As_{1-w} device sidewall (300), wherein w=1, an Alₓ Ga_{y} In_{1-x-y} P_{w} Nᵥ As_{1-v-w} sidewall interface (301), wherein v+w=1, and an Alₓ Ga_{y} In_{1-x-y} Nᵥ sidewall surface (302); and
wherein one or more dielectric materials comprising Al₂O₃ are deposited by atomic layer deposition (ALD) after sidewalls are surface-treated to passivate the surface-treated sidewalls.

2. The device of claim 1, wherein the gallium-containing semiconductor layers include one or more nitrogen or phosphorus atoms as counter atoms.

3. The device of claim 1, wherein the micro light emitting diode has a sidewall perimeter to light emitting area ratio larger than 0.04 µm⁻¹.

4. The device of claim 1, wherein the micro light emitting diode has one or more edges with a length of less than 80 µm.

5. The device of claim 1, wherein the dielectric materials are conformal or uniform in covering the surface-treated sidewalls.

6. The device of claim 1, wherein the dielectric materials are deposited by atomic layer deposition.

7. The device of claim 1, further comprising a post-dielectric deposition to improve material quality and an interface between the dielectric materials and the sidewalls.

## Patentansprüche

1. Vorrichtung, umfassend:
eine oder mehrere galliumhaltige Halbleiterschichten, die auf einem Substrat aufgewachsen sind und eine Mikro-Leuchtdiode (MicroLED) bilden, wobei die galliumhaltigen Halbleiterschichten Materialien umfassen, die Elemente der Gruppe III und der Gruppe V mit der chemischen Formel AlₓGa_{y}In_{z}NᵥP_{w}Asᵤ wobei 0≤x≤1, 0≤y≤1, 0≤z≤1, 0≤v≤1, 0≤w≤1, 0≤u≤1, v+w+u=1 und x+y+z=1, wobei die Materialien aus einem Substrat (100, 200) und AlₓGa_{y}In_{1-x-y}P_{w}As_{1-w} (101), das auf dem Substrat (100, 200) aufgewachsen ist, oder wobei die Materialien aus einem Substrat (100, 200) und n-dotiertem AlₓGa_{y}In_{1-x-y}P_{w}As_{1- w} (201) auf dem Substrat (100, 200) aufgebracht wird, gefolgt vom Aufwachsen eines aktiven Bereichs (202) und eines p-dotierten AlₓGa_{y}In_{1-x-y}P_{w}As_{1-w} (203);
wobei die galliumhaltigen Halbleiterschichten trockengeätzt werden, um eine Mesa der Mikro-Leuchtdiode und Seitenwände der Mesa zu definieren;
wobei die Seitenwände der trockengeätzten Mesa der Mikro-Leuchtdiode durch abwechselnde Impulszyklen aus Trimethylaluminium (TMA) und Stickstoffplasma mit geringer Leistung oberflächenbehandelt werden, um Schäden an den trockengeätzten Seitenwänden zu beseitigen oder die Oberflächenchemie der Seitenwände so zu verändern, dass keine Abscheidung durch das TMA und das Stickstoffplasma stattfindet und dass das Bauelement nach der Stickstoffplasma-Behandlung ein AlGaInP-Bauelement ist, das eine Alₓ Ga_{y} In_{1-x-y} P_{w} As_{1-w} -Vorrichtungsseitenwand (300), wobei w=1, eine Alₓ Ga_{y} In_{1-x-y} P_{w} Nᵥ As_{1- v-w} -Seitenwandgrenzfläche (301), wobei v+w=1, und eine Alₓ Ga_{y} In_{1-x-y} Nᵥ - Seitenwandoberfläche (302); und
wobei ein oder mehrere dielektrische Materialien, die Al₂O₃ enthalten, mittels Atomlagenabscheidung (ALD) abgeschieden werden, nachdem die Seitenwände oberflächenbehandelt wurden, um die oberflächenbehandelten Seitenwände zu passivieren.

2. Vorrichtung nach Anspruch 1, wobei die galliumhaltigen Halbleiterschichten ein oder mehrere Stickstoff- oder Phosphoratome als Gegenatome enthalten.

3. Vorrichtung nach Anspruch 1, wobei die Mikro-Leuchtdiode ein Verhältnis von Seitenwandumfang zu Leuchtfläche von mehr als 0,04 µm⁻¹ aufweist.

4. Vorrichtung nach Anspruch 1, wobei die Mikro-Leuchtdiode eine oder mehrere Kanten mit einer Länge von weniger als 80 µm aufweist.

5. Vorrichtung nach Anspruch 1, wobei die dielektrischen Materialien die oberflächenbehandelten Seitenwände konform oder gleichmäßig bedecken.

6. Vorrichtung nach Anspruch 1, wobei die dielektrischen Materialien durch Atomlagenabscheidung abgeschieden werden.

7. Vorrichtung nach Anspruch 1, die ferner eine nachträgliche dielektrische Abscheidung umfasst, um die Materialqualität und die Grenzfläche zwischen den dielektrischen Materialien und den Seitenwänden zu verbessern.

## Revendications

1. Dispositif comprenant :
une ou plusieurs couches semi-conductrices contenant du gallium, formées par croissance sur un substrat et constituant une microdiode électroluminescente (microLED), dans lequel les couches semi-conductrices contenant du gallium comprennent des matériaux qui contiennent des éléments des groupes III et V, ayant pour formule chimique AlₓGa_{y}In_{z}NᵥP_{w}Asᵤ où 0≤x≤1, 0≤y≤1, 0≤z≤1, 0≤v≤1, 0≤w≤1, 0≤u≤1, v+w+u=1, et x+y+z=1, lesdits matériaux étant constitués d'un substrat (100, 200) et d' AlₓGa_{y}In_{1-x-y}P_{w}As_{1-w} (101) développé sur le substrat (100, 200) ou dans lequel les matériaux sont constitués d'un substrat (100, 200) et d' AlₓGa_{y}In_{1-x-y}P_{w}As_{1-w} (201) dopé de type n, développé sur le substrat (100, 200), suivie de la croissance d'une région active (202) et d'un AlₓGa_{y}In_{1-x-y}P_{w}As_{1-w} (203) dopé de type p ;
dans lequel les couches semi-conductrices contenant du gallium sont gravées à sec afin de définir une mesa de la micro-diode électroluminescente et les parois latérales de la mesa ;
dans lequel les parois latérales de la mesa gravée à sec de la micro-diode électroluminescente sont soumises à un traitement de surface par des cycles d'impulsions alternés de triméthylaluminium (TMA) et de plasma d'azote à faible puissance afin d'éliminer les dommages subis par les parois latérales lors de la gravure à sec ou de modifier la composition chimique de la surface de ces parois, de telle sorte qu'il n'y ait aucun dépôt provenant du TMA et du plasma d'azote et que le dispositif soit un dispositif en AlGaInP après le traitement au plasma d'azote, comprenant une paroi latérale (300) du dispositif en Alₓ Ga_{y} In_{1-xy} P_{w} As_{1-w} (300), où w = 1, une interface paroi latérale Alₓ Ga_{y} In_{1-x-y} P_{w} Nᵥ As_{1-v-w} (301), où v+w=1, et une surface de paroi latérale (302) en Alₓ Ga_{y} In_{1-x-y} Nᵥ; et
dans lequel un ou plusieurs matériaux diélectriques comprenant del' Al₂O₃ sont déposés par dépôt par couche atomique (ALD) après que les parois latérales ont été traitées en surface afin de passiver les parois latérales traitées en surface.

2. Dispositif selon la revendication 1, dans lequel les couches semi-conductrices contenant du gallium comprennent un ou plusieurs atomes d'azote ou de phosphore en tant qu'atomes de contre-ion.

3. Dispositif selon la revendication 1, dans lequel la microdiode électroluminescente présente un rapport entre le périmètre des parois latérales et la surface d'émission de lumière supérieur à 0,04 µm⁻¹.

4. Dispositif selon la revendication 1, dans lequel la microdiode électroluminescente présente un ou plusieurs bords d'une longueur inférieure à 80 µm.

5. Dispositif selon la revendication 1, dans lequel les matériaux diélectriques recouvrent de manière conforme ou uniforme les parois latérales traitées en surface.

6. Dispositif selon la revendication 1, dans lequel les matériaux diélectriques sont déposés par dépôt par couche atomique.

7. Dispositif selon la revendication 1, comprenant en outre un dépôt post-diélectrique destiné à améliorer la qualité du matériau et l'interface entre les matériaux diélectriques et les parois latérales.
